# EUROPEAN PATENT SPECIFICATION

(11) **EP 3 005 901 B1**
(45) Date of publication and mention of the grant of the patent: **22.05.2019**
(21) Application number: 14188099.7
(22) Date of filing: 08.10.2014
(51) Int. Cl.: A47B 88/43, H05K 7/14

(54) **Slide rail assembly**
Schienenanordnung
Ensemble de rail de glissement

(43) Date of publication of application: 13.04.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Ho, Chun-Yi, Kaohsiung City (TW); Wang, Chun-Chiang, Kaohsiung City (TW)
(74) Representative: Viering, Jentschura & Partner mbB Patent- und Rechtsanwälte

(56) References cited:
- EP-A1- 2 540 191

## Description

### Field of the Invention

The present invention relates to a slide rail and, more particularly, to a slide rail assembly in which, by means of a retaining member, a second rail when retracted relative to a first rail can restrict displacement of the movable member of a bracket relative to the retaining member. Further the present invention relates to a system comprising a rack, a chassis and a slide rail assembly.

### Background of the Invention

In a slide rail system for use with servers, each of the two corresponding lateral sides of a server is mounted to a rack typically by a slide rail assembly and the two brackets mounted respectively at the two ends of the slide rail assembly. Generally, each bracket has at least one mounting member to be mounted to a corresponding mounting hole in the rack, and each of the front brackets has a movable member to be blocked by or fastened at the front end of the rack. The movable members are provided to keep the slide rail assemblies from falling off from the rack. The foregoing structure has been disclosed in, for example, US 7,357,362 B2 and US 8,371,454 B2.

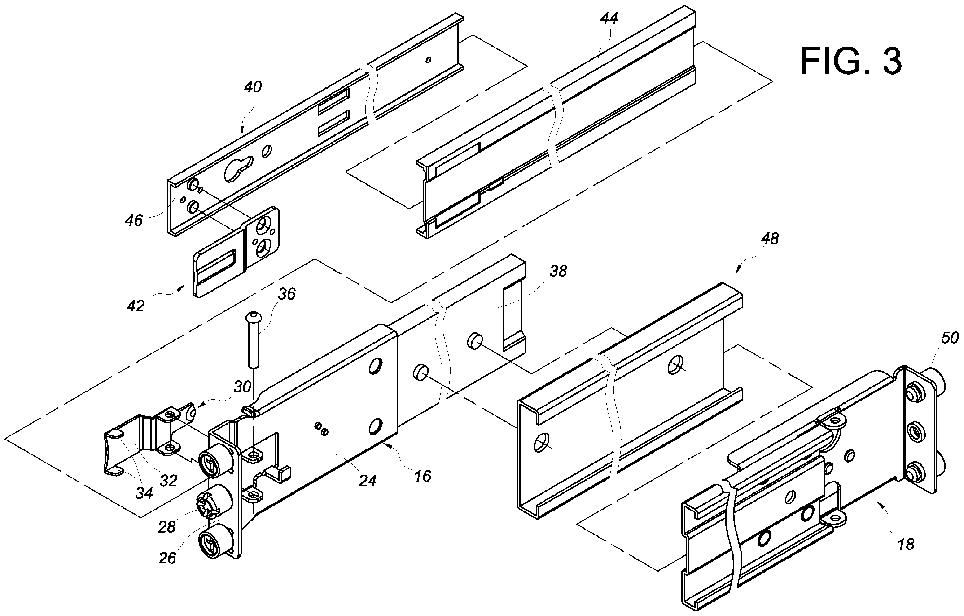

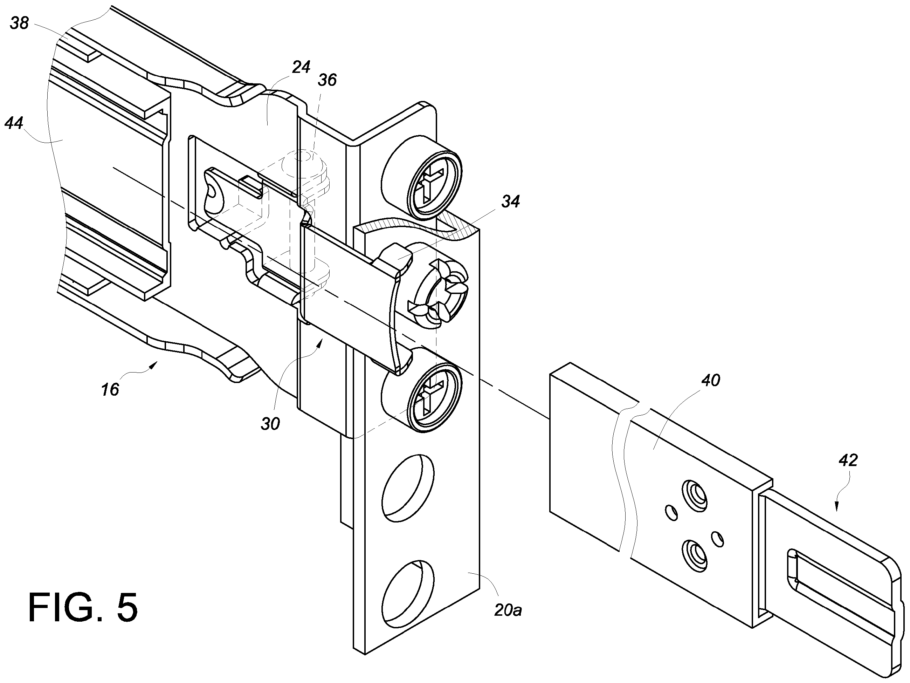

According to the specification, figure 3, and figure 5 of the afore-cited '362 B2 patent, a slide rail assembly is mounted to a mounting hole (71) of a rack (7) via the mounting member (2) of a bracket (1), and the retaining portion (431) of a movable member (42) (see figure 5 of the '362 B2 patent) is configured to be blocked by or fastened at the front end of the rack (7) so as to prevent the slide rail assembly from falling off from the rack (7).

It can be known from the technical disclosures of the afore-cited US patents that the brackets in the prior art typically include a movable member with a retaining portion to be blocked by or fastened at the front end of a rack. However, existing products need improvement to ensure that the movable member stays in the predetermined working state or predetermined position.

EP 2 540 191 A1 discloses a slide rail assembly including a first rail, a second rail, an engaging member and a resilient member. The first rail includes an extension wall and the second rail is slidably connected to the first rail, and has a passage. The engaging member is pivotably connected to the second rail, and has a first end and a second end. The first end includes a stop. The resilient member is connected between the second end of the engaging member and the second rail so as to provide a resilient force to the engaging member so that the stop of the first end of the engaging member is inserted into the passage of the second rail by the resilient force from the resilient member. The stop is longitudinally located corresponding to the extension wall of the first rail. When the second rail is slid to a pre-set position relative to the first rail, the stop of the engaging member contacts the extension wall of the first rail to form a stop point.

### Summary of the Invention

It is an object of the present invention to provide a system having a slide rail assembly in which, when a second rail has been retracted relative to a first rail, a retaining member can restrict displacement of the movable member of a bracket relative to the retaining member.

This object is achieved with a system comprising a rack, a chassis and a slide rail assembly according to claim 1 of the invention.

The system comprises a chassis, a rack and a slide rail assembly which is adapted to mount the chassis to the rack and comprises a first rail, a second rail longitudinally displaceable relative to the first rail, the second rail being mountable to the chassis, and a bracket to mount the rail assembly to the rack. The bracket comprises a side plate connected to the first rail, an end plate bent from the side plate, and a movable member movably connected to the side plate. The movable member has at least one retaining portion and is movable to an opened position and a closed position, in which in the assembled state the retaining portion of the movable member is blockable by a first post of the rack to ensure that the bracket will not fall off from said first post. The retaining portion corresponds to the end plate when the movable member has been operated and thereby moved to the closed position. The second rail or the chassis has a retaining member. When the second rail has been retracted relative to the first rail, the retaining member is able to restrict movement of the movable member from the closed position to the opened position. The retaining member is connected to the second rail by a connecting means or the retaining member is connected to the chassis by an attaching means or the retaining member is connected to the chassis by being integrally formed with the chassis.

Preferably, the retaining member is connected to the second rail by a connecting means, and each of the retaining member and the second rail has an assembly portion allowing the retaining member and the second rail to connect with each other.

Preferably, the second rail is longitudinally displaceable to a retraced position relative to the first rail, the side plate and the end plate of the bracket are in a substantially perpendicular arrangement, and the at least one retaining portion of the movable member is spaced from the end plate by a predetermined distance when the movable member has been operated and thereby moved to the closed position; and wherein when the second rail is in the retracted position relative to the first rail, at least a portion of the retaining member faces the movable member so that the retaining member is able to restrict lateral displacement of the movable member relative to the retaining member.

Preferably, the bracket further comprises a mounting member connected to the end plate and being mountable to a hole of the rack.

Preferably, the movable member is pivotally connected to the side plate by a connector.

According to another aspect which is not an aspect of the present invention, a slide rail assembly is configured for mounting a chassis to a rack. The slide rail assembly is mounted to the rack via at least one bracket. The rack includes a hole. The bracket includes a side plate, an end plate, a mounting member connected to the end plate and mounted to the hole of the rack, and a movable member movably connected to the side plate. The side plate and the end plate are in a substantially perpendicular arrangement. The movable member has a retaining portion and can be moved to a closed position and an opened position. The retaining portion of the movable member is blocked by the rack when the movable member has been operated and thereby moved to the closed position. The slide rail assembly includes a first rail, a second rail, and a retaining member. The first rail is connected to the side plate of the bracket. The second rail can be displaced longitudinally relative to the first rail. The chassis is mounted to the second rail. The retaining member is provided at at least one of the chassis and the second rail. When the second rail has been retracted relative to the first rail, the second rail can restrict, via the retaining member, movement of the movable member from the closed position to the opened position.

According to yet another aspect which is not an aspect of the present invention, a slide rail assembly includes a first rail, a second rail, a retaining member, and a bracket. The second rail can be displaced longitudinally relative to the first rail. The retaining member is connected to the second rail. The bracket includes a side plate connected to the first rail, an end plate bent from the side plate, and a movable member movably connected to the side plate. The movable member has a retaining portion and can be moved to a closed position and an opened position. The retaining portion of the movable member corresponds to the end plate when the movable member has been operated and thereby moved to the closed position. When the second rail has been retracted relative to the first rail, the second rail can, via the retaining member, restrict movement of the movable member from the closed position to the opened position.

Preferably, the movable member is pivotally connected to the side plate by a connector.

One of the advantageous features of the present invention is that, once the second rail has been retracted relative to the first rail, the retaining member can restrict displacement of the movable member of the bracket relative to the retaining member.

### Brief Description of the Drawings

The invention as well as a preferred mode of use and the advantages thereof will be best understood by referring to the following detailed description of some illustrative embodiments in conjunction with the accompanying drawings, in which:
Figure 1 is a perspective view showing how the slide rail assembly in the first embodiment of the present invention is applied to a server system;
Figure 2 is a perspective view showing how each slide rail assembly in Figure 1 is mounted to a rack via brackets;
Figure 3 is an exploded view of the slide rail assembly and brackets in Figure 2;
Figure 4A shows how the first rail and third rail of the slide rail assembly in the first embodiment of the present invention are mounted to a first post via the first bracket and how a movable member can be operated and moved to a closed position;
Figure 4B shows how the first rail and third rail of the slide rail assembly in the first embodiment of the present invention are mounted to the first post via the first bracket and how the movable member can be operated and moved to an opened position;
Figure 5 not only shows how the first rail and third rail of the slide rail assembly in the first embodiment of the present invention are mounted to the first post via the first bracket, but also shows the second rail schematically as separate from the third rail;
Figure 6A is a schematic drawing in which the second rail of the slide rail assembly in the first embodiment of the present invention is in a retracted position relative to the first rail;
Figure 6B is a schematic drawing in which the second rail of the slide rail assembly in the first embodiment of the present invention is in an extended position relative to the first rail;
Figure 7 schematically shows how the retaining member in the second embodiment, which is not an embodiment of the present invention is integrally formed with the second rail;
Figure 8 schematically shows how the retaining member in the third embodiment of the present invention is assembled to and thereby connected to the second rail; and
Figure 9 schematically shows how the retaining member and movable member in the fourth embodiment of the present invention are arranged relative to each other.

### Detailed Description of the Invention

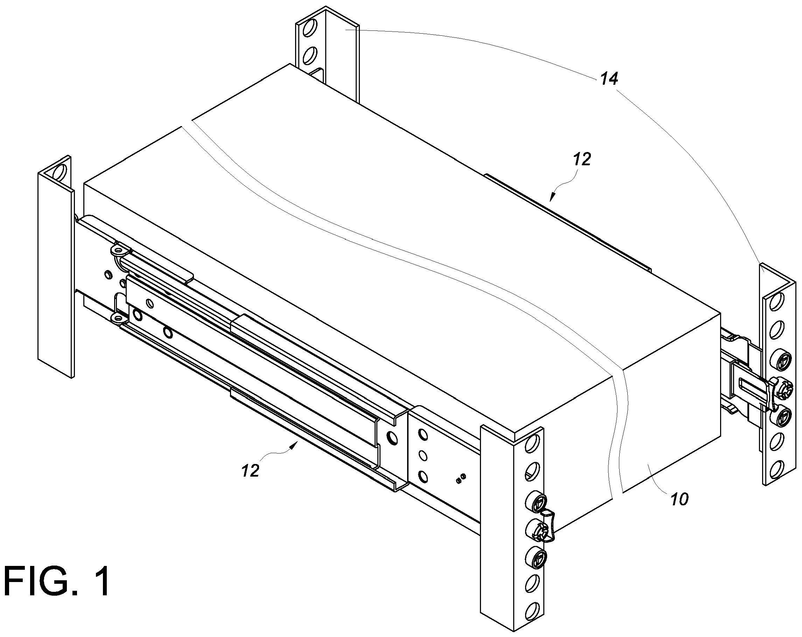

Figure 1 shows how the slide rail assembly in the first embodiment of the present invention is applied to a server system. The server system includes a server chassis 10 whose two corresponding lateral sides are mounted to a rack 14 by a pair of slide rail assemblies 12 respectively.

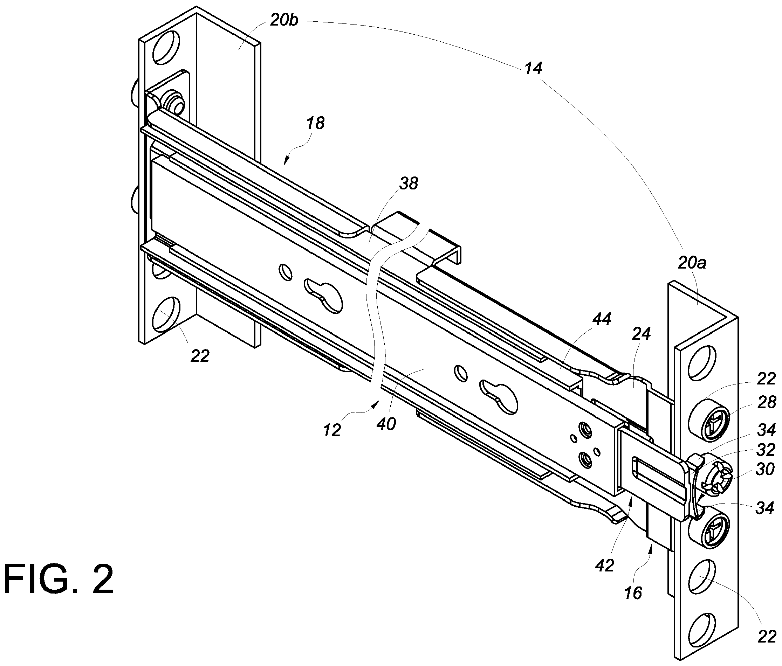

Figure 2 shows how a first bracket 16 and a second bracket 18 are mounted to two opposite portions (e.g., a front portion and a rear portion) of each slide rail assembly 12 in figure 1 respectively. Through the first bracket 16 and the second bracket 18, the two opposite portions of the slide rail assembly 12 can be mounted to a first post 20a and a second post 20b of the rack 14 respectively. Each of the first post 20a and the second post 20b includes at least one hole 22.

In one preferred embodiment as shown in figure 2 and figure 3, the first bracket 16 includes a side plate 24, an end plate 26 bent from the side plate 24, at least one mounting member 28 connected to the end plate 26, and a movable member 30 movably connected to the side plate 24.

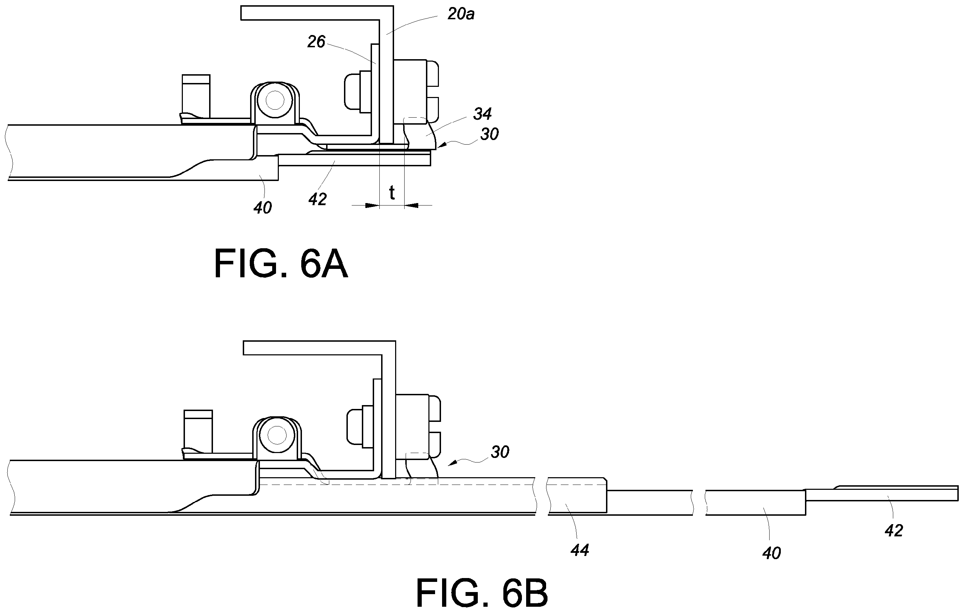

The side plate 24 and the end plate 26 are in a substantially perpendicular arrangement. The at least one mounting member 28 is mounted to the at least one hole 22 of the first post 20a respectively. The movable member 30 has a wall portion 32 and at least one retaining portion 34 bent from the wall portion 32. The at least one retaining portion 34 corresponds to, and is spaced a predetermined distance t away from, the end plate 26 (as can be seen more clearly in figure 6A). The wall portion 32 and the at least one retaining portion 34 are in a substantially perpendicular arrangement. The movable member 30 is movably connected to the side plate 24 by a connector 36. For example, the connector 36 pivotally connects the movable member 30 to the side plate 24.

The slide rail assembly 12 includes a first rail 38, a second rail 40, and a retaining member 42. Herein, the slide rail assembly 12 further includes a third rail 44. The first rail 38 includes an end portion (e.g., a front portion) connected to the side plate 24. The second rail 40 can be displaced longitudinally relative to the first rail 38. Herein, the second rail 40 is longitudinally movably connected to the first rail 38 via the third rail 44. The third rail 44 increases the distance by which the second rail 40 can be pulled out relative to the first rail 38. In another embodiment (not shown), however, the slide rail assembly 12 is a two-rail assembly. That is to say, the slide rail assembly of the present invention is not limited to the three-rail configuration disclosed in the embodiment in discussion.

The retaining member 42 is connected to the second rail 40. Preferably, the second rail 40 includes an end portion 46, and the retaining member 42 is connected by a connecting means to a portion of the second rail 40 that is adjacent to the end portion 46. The connecting means can be riveting, soldering, or other connection methods; the present invention imposes no limitations in this regard.

The second bracket 18 is connected to the opposite end portion (e.g., a rear portion) of the first rail 38 via an auxiliary member 48. Like the first bracket 16, the second bracket 18 includes at least one mounting member 50 to be mounted to the at least one hole 22 of the second post 20b respectively.

It can be known from the above that the slide rail assembly 12 can be mounted to the first post 20a and the second post 20b via the at least one mounting member 28 of the first bracket 16 and the at least one mounting member 50 of the second bracket 18, respectively.

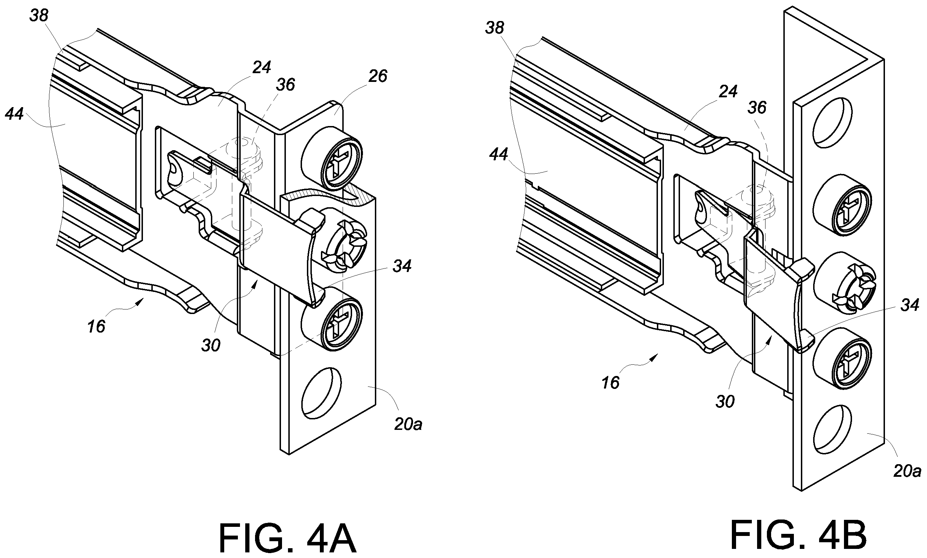

Figure 4A and figure 4B show how the first rail 38 and the third rail 44, which are longitudinally movably connected to each other, are mounted to the first post 20a via the first bracket 16. In the state shown in figure 4A and figure 4B, the first post 20a is located within the predetermined distance t (see figure 6A), and the at least one retaining portion 34 of the movable member 30 faces the first post 20a longitudinally or is pressed against the first post 20a, thereby preventing the first bracket 16 from falling off from the first post 20a.

Once the first bracket 16 is mounted to the first post 20a, the movable member 30, which is movably connected to the side plate 24 via the connector 36, can be operated relative to the side plate 24 by the operator so as to be moved to a closed position (see figure 4A) or an opened position (see figure 4B). When the movable member 30 is in the closed position, the at least one retaining portion 34 of the movable member 30 is blocked by the first post 20a (e.g., the at least one retaining portion 34 is blocked at the front end of the first post 20a) to ensure that the first bracket 16 will not fall off from the first post 20a.

However, the movable member 30, which is pivotally connected to the side plate 24 via the connector 36, tends to or is likely to open when subjected to external impact. Should the movable member 30 open by accident, the first post 20a of the rack 14 will have problem blocking the at least one retaining portion 34 of the movable member 30 securely. To prevent such a scenario, the retaining member 42 is provided. Referring to figure 5, once the first rail 38 and the third rail 44 are mounted to the first post 20a via the first bracket 16 and the at least one retaining portion 34 of the movable member 30 is blocked by the first post 20a, the retaining member 42 connected to the second rail 40 can restrict or stop lateral movement of the movable member 30, or to be more precise, the retaining member 42 can restrict pivotal movement of the movable member 30.

More specifically, referring to figure 5, figure 6A, and figure 6B, when the second rail 40 has been retracted relative to the first rail 38 (see figure 6A, in which the second rail 40 is in a retracted position relative to the first rail 38), at least a portion of the retaining member 42 faces the movable member 30; therefore, by means of the retaining member 42, the second rail 40 can restrict or stop lateral displacement of the movable member 30 relative to the retaining member 42. In other words, the foregoing design can restrict movement of the movable member 30 from the closed position to the opened position, allowing the first post 20a to firmly block the at least one retaining portion 34 of the movable member 30 so that the movable member 30 will not be lifted open (i.e., from the closed position to the opened position) by external impact.

When the second rail 40 is displaced longitudinally relative to the first rail 38 from the retracted position to an extended position (see figure 6B), the retaining member 42 is moved along with the second rail 40 to the extended position. When the second rail 40 is displaced longitudinally relative to the first rail 38 from the extended position to the retracted position (see figure 6A), the retaining member 42 is moved back to the retracted position along with the second rail 40. As such, the retaining member 42 will not interfere with relative displacement of the rails during extension or retraction.

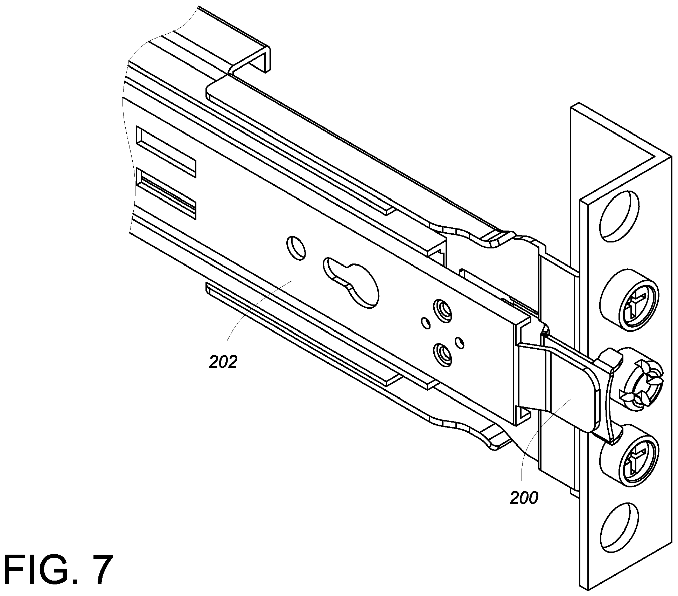

Figure 7 shows the second embodiment which is not an embodiment of the present invention, in which the retaining member 200 is integrally formed with the second rail 202. For example, the retaining member 200 is integrally formed with the second rail 202 at a position adjacent to an end portion of the second rail 202.

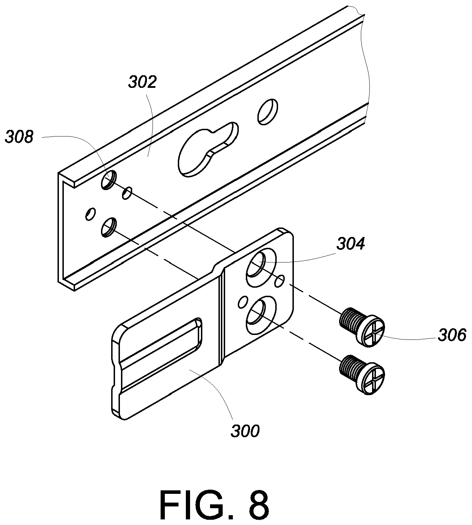

Figure 8 shows the third embodiment of the present invention, in which the retaining member 300 and the second rail 302 have an assembly portion 304 and an assembly portion 308 respectively so that the retaining member 300 and the second rail 304 can be connected together by assembly. For example, the retaining member 300 has at least one assembly portion 304 which can be connected to the at least one assembly portion 308 of the second rail 302 via at least one assembly member 306 respectively. Thus, the retaining member 300 can be assembled to or detached from the second rail 302 with ease.

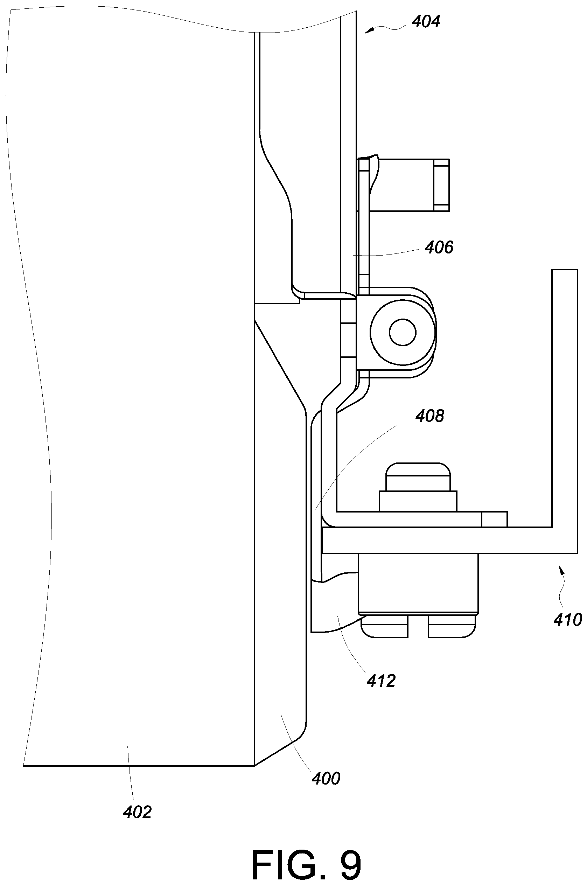

Figure 9 shows the fourth embodiment of the present invention, in which the retaining member 400 is provided on a chassis 402. The retaining member 400 is implemented as a stud, a projecting block, or a like protuberance formed by the chassis 402 or is mounted to the chassis 402 by an attaching means; the present invention has no limitations in this respect. Generally, the chassis 402 is mounted between a pair of slide rail assemblies 404, though only one of the slide rail assemblies 404 is depicted in figure 9. As shown in the drawing, the slide rail assembly 404 includes a bracket 406 (first bracket) and a movable member 408 movably (e.g., pivotally) connected to the bracket 406. The slide rail assembly 404 is mounted to a rack 410 via the bracket 406. The movable member 408 has at least one retaining portion 412 to be blocked by or pressed against the rack 410 so as to ensure that the slide rail assembly 404 is firmly and safely mounted to the rack 410. When the chassis 402 has been displaced via the slide rail assembly 404 to a retracted position relative to the rack 410, at least a portion of the retaining member 400 corresponds to the movable member 408 and can thereby restrict or stop lateral displacement of the movable member 408 relative to the retaining member 400. This mode of implementation, therefore, is equally capable of ensuring that the movable member 408 stays in the predetermined working state. In other words, should improper application of force result in collision or shocks when the chassis 402 is pushed and retracted into the rack 410, the aforesaid arrangement of the retaining member 400 guarantees that the movable member 408 will not disengage from the rack 410.

While the present invention has been disclosed via the foregoing preferred embodiments, it is understood that those embodiments are not intended to be restrictive of the present invention. The scope of patent protection, if granted, is defined by the appended claims.

## Claims

1. A system comprising a chassis (10, 402), a rack (14, 410) and a slide rail assembly (12, 404), adapted to mount the chassis (10, 402) to the rack (14, 410), the slide rail assembly (12, 404) comprising:
a first rail (38);
a second rail (40, 202, 302) longitudinally displaceable relative to the first rail (38), the second rail (40, 202, 302) being mountable to the chassis (10, 402); and
a bracket (16, 406) to mount the slide rail assembly (12, 404) to the rack (14, 410), the bracket (16, 406) comprising a side plate (24) connected to the first rail (38), an end plate (26) bent from the side plate (24), and a movable member (30, 408) movably connected to the side plate (24), wherein
the movable member (30, 408) has at least one retaining portion (34, 412) and is movable to an opened position and a closed position,
in which in the assembled state the retaining portion (34) of the movable member (30) is blocked by a first post (20a) of the rack (14, 410) to ensure that the bracket (16, 406) will not fall off from said first post (20a), and wherein
the retaining portion (34, 412) corresponds to the end plate (26) when the movable member (30, 408) has been operated and thereby moved to the closed position; wherein
the second rail (40, 202, 302) or the chassis (10, 402) having a retaining member (42, 200, 300, 400), and wherein
when the second rail (40, 202, 302) has been retracted relative to the first rail (38), the retaining member (42, 200, 300, 400) is able to restrict movement of the movable member (30, 408) from the closed position to the opened position, wherein
the retaining member (42, 200, 300) is connected to the second rail (40, 202, 302) by a connecting means or
the retaining member (400) is connected to the chassis (402) by an attaching means or
the retaining member (400) is connected to the chassis (402) by being integrally formed with the chassis (402).

2. The system as claimed in claim 1, wherein the retaining member (42, 200, 300) is connected to the second rail (40, 202, 302) by a connecting means, and each of the retaining member (42, 200, 300) and the second rail (40, 202, 302) has an assembly portion (304, 308) allowing the retaining member (42, 200, 300) and the second rail (40, 202, 302) to connect with each other.

3. The system as claimed in claim 1, wherein the second rail (40, 202, 302) is longitudinally displaceable to a retraced position relative to the first rail (38), the side plate (24) and the end plate (26) of the bracket (16, 406) are in a substantially perpendicular arrangement, and the at least one retaining portion (34) of the movable member (30, 408) is spaced from the end plate (26) by a predetermined distance (t) when the movable member (30, 408) has been operated and thereby moved to the closed position; and wherein when the second rail (40, 202, 302) is in the retracted position relative to the first rail (38), at least a portion of the retaining member (42, 200, 300, 400) faces the movable member (30, 408) so that the retaining member (42, 200, 300, 400) is able to restrict lateral displacement of the movable member (30, 408) relative to the retaining member (42, 200, 300, 400).

4. The system as claimed in claim 3, wherein the retaining member (42, 200, 300) is connected to the second rail (40, 202, 302) by a connecting means, and each of the retaining member (42, 200, 300) and the second rail (40, 202, 302) has an assembly portion (304, 308) allowing the retaining member (42, 200, 300) and the second rail (40, 202, 302) to connect with each other.

5. The system as claimed in claim 1, wherein the bracket (16, 406) further comprises a mounting member (28) connected to the end plate (26) and being mountable to a hole (22) of the rack (14, 410).

6. The system as claimed in any one of claims 1-5, wherein the movable member (30, 408) is pivotally connected to the side plate (24) by a connector (36).

## Patentansprüche

1. Ein System mit einem Fahrwerk (10, 402), einem Gestell (14, 410) und einer Laufschienenmontage (12, 404), mit denen das Fahrwerk (10, 402) an das Gestell (14, 410) montiert wird; die Laufschienenmontage (12, 404) die folgenden Komponenten umfasst:
eine erste Schiene (38);
eine zweite Schiene (40, 202, 302), die der Länge nach an der ersten Schiene (38) verschiebbar ist; die zweite Schiene (40, 202, 302) an das Fahrwerk (10, 402) montiert werden kann; und
einen Träger (16, 406), um die Laufschienenmontage (12, 404) an das Gestell (14, 410) zu montieren; der Träger (16, 406) eine Seitenplatte (24) umfasst, die an der ersten Schiene (38) befestigt ist; eine Endplatte (26) von der Seitenplatte (24) gebogen ist; ein bewegliches Glied (30, 408) beweglich an der Seitenplatte (24) befestigt ist, wobei
das bewegliche Glied (30, 408) mit mindestens einem Halteabschnitt (34, 412) gebildet ist und in eine geöffnete Position und eine geschlossene Position bewegt werden kann,
wobei der Halteabschnitt (34) des beweglichen Glieds (30) im montierten Zustand mit einer ersten Stange (20a) des Gestells (14, 410) blockiert wird, um den Träger (16, 406) an der ersten Stange (20a) zu sichern und damit dieser nicht von der ersten Stange (20a) abfallen kann, und wobei der Halteabschnitt (34, 412) nach dem Betätigen des beweglichen Glieds (30, 408) mit der Endplatte (26) übereinstimmt und dadurch das bewegliche Glied (30, 408) in die geschlossene Position bewegt wird; wobei die zweite Schiene (40, 202, 302) oder das Fahrwerk (10, 402) ein Halteglied (42, 200, 300, 400) aufweisen, und wobei
nach dem Einziehen der zweiten Schiene (40, 202, 302) an der ersten Schiene (38) das Halteglied (42, 200, 300, 400) die Bewegung des beweglichen Glieds (30, 408) von der geschlossenen Position in die geöffnete Position begrenzen kann, wobei
das Halteglied (42, 200, 300) mit Befestigungselementen an der zweiten Schiene (40, 202, 302) befestigt ist oder
das Halteglied (400) durch Anbringen am Fahrwerk (402) befestigt ist oder das Halteglied (400) durch einstückiges Ausbilden mit dem Fahrwerk (402) am Fahrwerk (402) befestigt ist.

2. Das System nach Anspruch 1, wobei das Halteglied (42, 200, 300) mit Befestigungselementen an der zweiten Schiene (40, 202, 302) befestigt ist; jedes Halteglied (42, 200, 300) und die zweite Schiene (40, 202, 302) einen Montageabschnitt (304, 308) aufweisen, um das Halteglied (42, 200, 300) und die zweite Schiene (40, 202, 302) aneinander zu befestigen.

3. Das System nach Anspruch 1, wobei die zweite Schiene (40, 202, 302) der Länge nach an der ersten Schiene (38) eingezogen werden kann; die Seitenplatte (24) und die Endplatte (26) des Trägers (16, 406) im Wesentlichen vertikal angeordnet sind; der mindestens eine Halteabschnitt (34) des beweglichen Glieds (30, 408) in einem vorbestimmten Abstand (t) zur Endplatte (26) angeordnet ist, nachdem das bewegliche Glied (30, 408) betätigt und daher in die geschlossene Position bewegt wurde; wenn die zweite Schiene (40, 202, 302) an der ersten Schiene (38) eingezogen ist mindestens ein Abschnitt des Halteglieds (42, 200, 300, 400) gegenüber dem beweglichen Glied (30, 408) angeordnet ist, so dass mit dem Halteglied (42, 200, 300, 400) die laterale Verschiebung des beweglichen Glieds (30, 408) relativ zum Halteglied (42, 200, 300, 400) begrenzt werden kann.

4. Das System nach Anspruch 3, wobei das Halteglied (42, 200, 300) mit Befestigungselementen an der zweiten Schiene (40, 202, 302) befestigt ist; jedes Halteglied (42, 200, 300) und die zweite Schiene (40, 202, 302) einen Montageabschnitt (304, 308) aufweisen, um das Halteglied (42, 200, 300) und die zweite Schiene (40, 202, 302) aneinander zu befestigen.

5. Das System nach Anspruch 1, wobei der Träger (16, 406) weiter ein Montageglied (28) umfasst, das an der Endplatte (26) befestigt ist und an ein Loch (22) im Gestell (14, 410) montiert werden kann.

6. Das System nach einem der Ansprüche 1-5, wobei das bewegliche Glied (30, 408) mit einem Anschluss (36) drehgelenkig an der Seitenplatte (24) befestigt ist.

## Revendications

1. Système comprenant un boîtier (10, 402), un rack (14, 410) et un ensemble rail coulissant (12, 404), adapté pour monter le boîtier (10, 402) sur le rack (14, 410), l'ensemble rail coulissant (12, 404) **caractérisé par le fait qu'**il comprend :
un premier rail (38) ;
un second rail (40, 202, 302) déplaçable longitudinalement par rapport au premier rail (38), le second rail (40, 202, 302) pouvant être monté sur le boîtier (10, 402) ; et
un support (16, 406) pour monter l'ensemble rail coulissant (12, 404) sur le rack (14, 410), le support (16, 406) comprenant une plaque latérale (24) raccordée au premier rail (38), une plaque arrière (26) pliée à partir de la plaque latérale (24), et un élément mobile (30, 408) raccordé de manière mobile à la plaque latérale (24),
l'élément mobile (30, 408) comporte au moins une partie de retenue (34, 412) et est déplaçable vers une position ouverte et vers une position fermée,
à l'état monté la partie de retenue (34) de l'élément mobile (30) est bloquée par un premier montant (20a) du rack (14, 410) pour s'assurer que le support (16, 406) ne tombera pas dudit premier montant (20a), et
la partie de retenue (34, 412) correspond à la plaque arrière (26) lorsque l'élément mobile (30, 408) a été actionné et ainsi déplacé vers la position fermée ;
le second rail (40, 202, 302) ou le boîtier (10, 402) comportant un élément de retenue (42, 200, 300, 400), et
lorsque le second rail (40, 202, 302) a été rétracté par rapport au premier rail (38), l'élément de retenue (42, 200, 300, 400) est capable de restreindre le mouvement de l'élément mobile (30, 408) depuis la position fermée vers la position ouverte,
l'élément de retenue (42, 200, 300) est raccordé au second rail (40, 202, 302) par un moyen de raccordement ou
l'élément de retenue (400) est raccordé au boîtier (402) par un moyen de fixation ou
l'élément de retenue (400) est raccordé au boîtier (402) en étant formé intégralement avec le boîtier (402).

2. Système selon la revendication 1, **caractérisé par le fait que** l'élément de retenue (42, 200, 300) est raccordé au second rail (40, 202, 302) par un moyen de raccordement, et l'élément de retenue (42, 200, 300) et le second rail (40, 202, 302) comportent tous les deux une partie d'assemblage (304, 308) permettant à l'élément de retenue (42, 200, 300) et au second rail (40, 202, 302) de se raccorder l'un à l'autre.

3. Système selon la revendication 1, **caractérisé par le fait que** le second rail (40, 202, 302) est déplaçable longitudinalement vers une position rétractée par rapport au premier rail (38), la plaque latérale (24) et la plaque arrière (26) du support (16, 406) sont disposées de manière sensiblement perpendiculaire, et la ou les parties de retenue (34) de l'élément mobile (30, 408) sont séparées de la plaque arrière (26) par une distance prédéterminée (t) lorsque l'élément mobile (30, 408) a été actionné et ainsi déplacé vers la position fermée ; et lorsque le second rail (40, 202, 302) est dans la position rétractée par rapport au premier rail (38), au moins une partie de l'élément de retenue (42, 200, 300, 400) fait face à l'élément mobile (30, 408) de sorte que l'élément de retenue (42, 200, 300, 400) est capable de restreindre le déplacement latéral de l'élément mobile (30, 408) par rapport à l'élément de retenue (42, 200, 300, 400).

4. Système selon la revendication 3, **caractérisé par le fait que** l'élément de retenue (42, 200, 300) est raccordé au second rail (40, 202, 302) par un moyen de raccordement, et l'élément de retenue (42, 200, 300) et le second rail (40, 202, 302) comportent une partie d'assemblage (304, 308) permettant à l'élément de retenue (42, 200, 300) et au second rail (40, 202, 302) de se raccorder l'un à l'autre.

5. Système selon la revendication 1, **caractérisé par le fait que** le support (16, 406) comprend en outre un élément de montage (28) raccordé à la plaque arrière (26) et pouvant être monté sur un trou (22) du rack (14, 410).

6. Système selon l'une quelconque des revendications 1-5, **caractérisé par le fait que** l'élément mobile (30, 408) est raccordé de manière pivotante à la plaque latérale (24) par une attache (36).
